Europäisches Patentamt

European Patent Office

Office européen des brevets

(11) Publication number: **0 183 724**
**B1**

# EUROPEAN PATENT SPECIFICATION

(45) Date of publication of patent specification: **02.08.89**

(51) Int. Cl.⁴: **H 01 L 23/50,** H 01 L 23/48

(21) Application number: **85902347.5**

(22) Date of filing: **22.04.85**

(86) International application number:
**PCT/US85/00743**

(87) International publication number:
**WO 85/05735 19.12.85 Gazette 85/27**

(54) **INTEGRATED CIRCUIT PACKAGE.**

(30) Priority: **04.06.84 US 616823**

(43) Date of publication of application:
**11.06.86 Bulletin 86/24**

(45) Publication of the grant of the patent:
**02.08.89 Bulletin 89/31**

(84) Designated Contracting States:
**DE FR GB IT NL**

(56) References cited:
**GB-A-2 084 796**
**GB-A-2 091 035**
**US-A-4 346 396**

(73) Proprietor: **AMERICAN TELEPHONE AND TELEGRAPH COMPANY**
**550 Madison Avenue**
**New York, NY 10022 (US)**

(72) Inventor: **MOYER, Harold William**
**1602 Ruth Street**
**Allentown, PA 18104 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

Courier Press, Leamington Spa, England.

## Description

Integrated circuit chips have grown in size and packing density to meet user demand for more functions and storage capacity at lower cost. With this development, advantages in distributing electrical power to the chip become important.

A common approach is to incorporate a power distribution network into the chip itself. However, the power busses tend to be large and the chip size must be increased, or functional space sacrificed, to accommodate them. This is generally undesirable.

An alternative to increasing the chip size to accommodate the power distribution network is to distribute the power off chip and introduce power between more than two chip terminals. However, each new chip terminal consumes a package terminal pin and it is desirable to avoid multiple pins for power as well as to avoid separate power distribution means on the mounting board.

Thus, a need exists for distributing electrical power to a chip in a manner which neither requires an increase in chip size nor the use of extra terminal pins.

WO 85/01835 is a published International patent application which designates, for a European patent, all of the presently designated states except Italy. It forms part of the state of the art in respect of the commonly designated states by virtue of Article 54(3) EPC. A device is described in which a chip is supported by a chip support paddle forming part of the lead frame. The paddle comprises two separate portions, both electrically isolated from each other and from the back-side of the chip. Conductive wire bonds connect each of the portions of the paddle with a plurality of sites on the chip for providing power connections. A conductive connection to the back-side of the chip is formed by a conductive layer on the insulating film which separates the chip from the paddle.

In the invention as set out in claim 1 one or more cross-under members are provided which can be used for power connections to a plurality of sites on the chip whilst the paddle itself forms the connection to the back-side of the chip.

Brief description of the drawings

Fig. 1 is a perspective view of a lead frame designed in accordance with one aspect of the invention;

Fig. 2 is a perspective view, partly cut away, of the lead frame encapsulated in a plastic package;

Fig. 3 is a view similar to Fig. 2 showing a chip installed in the package.

Detailed description

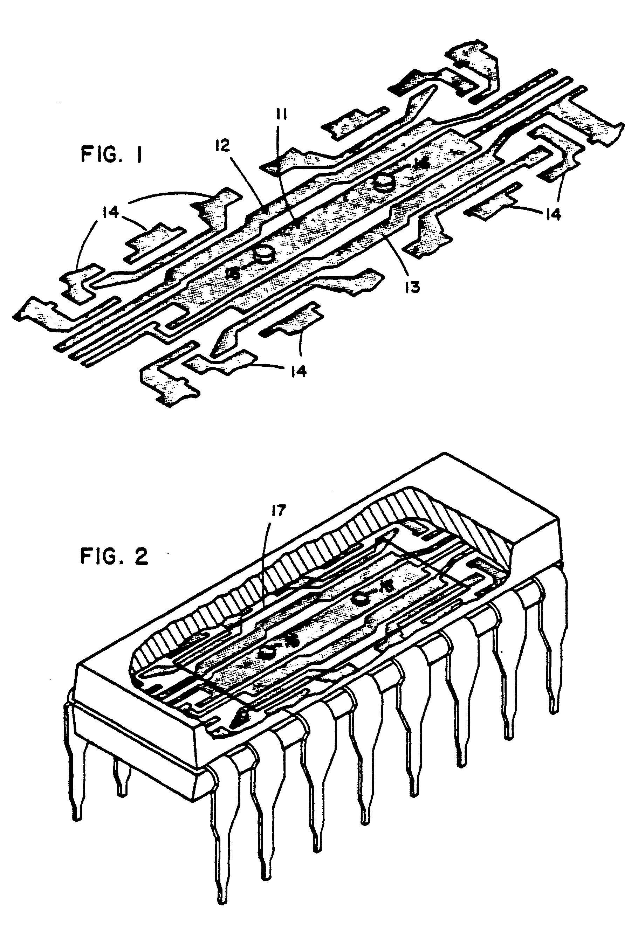

A lead frame designed in accordance with the invention is shown in Fig. 1. The lead frame is standard except for the interior portion, often referred to as the paddle portion.

The elongated section 11 extends the length of the chip that will later be attached to the lead frame, and serves both as the chip support and the contact to the back of the chip. Alongside the paddle member are crossunder members 12 and 13 which also extend the length of the chip, plus an additional length sufficient to provide wire bonding sites as will later be shown. The remainder of the lead frame is conventional with a plurality of bonding sites 14 shown arranged around the periphery of the central paddle and crossunder region. It will be understood by those skilled in the art that the frame shown is typically part of an endless tape with repeating lead frame units onto which chips are attached in assembly line fashion. Affixed to, or integral with, the central paddle member 11 are contact pins 16. The lead frame of Fig. 1 is shown in Fig. 2 installed in a conventional plastic packaging material but with the chip removed to show the lead frame detail. Covering the crossunder members 12 and 13 is an insulating film 17 made for example, from mylar or the like. Openings in the film 17 are provided for the protruding pins 16. When the chip is installed over the central portion of the lead frame the back of the chip will be insulated from the crossunder members 12 and 13, but will electrically contact the paddle member 11 via pins 16. Provision is made at one, or both, ends of the paddle 11 to accommodate a backplane wire contact. Alternatively, paddle 11 may communicate electrically with an external lead. The means for establishing electrical contact between the back of the chip and the paddle member 11 may assume a variety of forms. The pin arrangement of Fig. 1 is but one choice. The contact means may be, for example, simply an opening in the insulating film to allow the chip to be soldered or conductively bonded directly to the member 11.

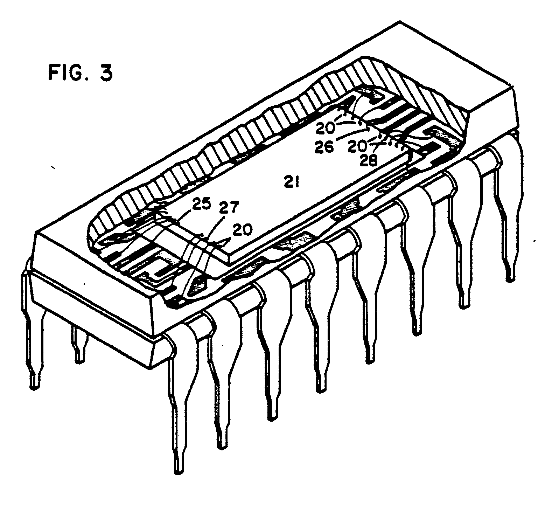

The completed package is shown in Fig. 3 with a portion cut away, as in Fig. 2, to show the manner in which the chip 21 is installed in the package. Here wire bonds 20 are shown extending from the various bonding sites 14 (Fig. 1) on the lead frame to bonding sites on the chip 21. Bonds to crossunder 12 are shown at 25 and 26, and bonds to crossunder 13 are shown at 27 and 28.

To distribute power to various sites on the chip 21, power is applied, via two package terminal pins, between the two cross-unders 12 and 13, and thence to the chip sites via the wire bonds 25—27. Additional sites on the chip can be similarly connected to the cross-unders (power busses) 12 and 13. Thus, while but two terminal pins are allocated to applying power to the chip, any number of sites on the chip 21 can receive power.

## Claims

1. An integrated circuit device comprising a lead frame which includes a chip support paddle (11) and one or more cross-under members (12, 13), a semiconductor chip (21) overlying the chip support paddle and the one or more cross-under members, the back-side of the chip making electrical contact with the chip support paddle but being electrically insulated from the one or more cross-under members, and conductive wire bonds (25—28) electrically connecting the or each cross-under member with a plurality of sites on the chip.

2. A device as claimed in claim 1 having at least two crossunder members (11, 12).

3. A device as claimed in claim 1 or claim 2 in which the back-side of the semiconductor chip contacts the chip support paddle by means of pins (16) extending from said paddle into contact with said back-side.

4. A device as claimed in any of the preceding claims including a film of dielectric material (17) between the chip and the one or more crossunder members with openings in the film through which the back-side of the chip contacts the said paddle.

5. A device as claimed in claim 4 as dependent on claim 3 in which the pins are integral with the paddle and extend through said openings.

## Patentansprüche

1. Integriertes Schaltungsbauteil mit einem Drahtrahmen, der ein Chip-Trägerpaddel (11) und ein oder mehrere Unterkreuzungsglieder (12, 13) enthält, wobei ein Halbleiter-Chip (21) auf dem Chip-Trägerpaddel und dem oder den Unterkreuzungsgliedern liegt, die Rückseite des Halbleiter-Chips in elektrischem Kontakt mit dem Chip-Trägerpaddel steht, aber elektrisch von dem oder den Unterkreuzungsgliedern isoliert ist, und mit leitenden Bonddrähten (25—28), die das oder jedes Unterkreuzungsglied elektrisch mit einer Vielzahl von Stellen auf dem Halbleiter-Chip verbinden.

2. Bauteil nach Anspruch 1, das wenigstens zwei Unterkreuzungsglieder (11, 12) aufweist.

3. Bauteil nach Anspruch 1 oder 2, bei dem die Rückseite des Halbleiter-Chips das Chip-Trägerpaddel mit Hilfe von Stiften (16) berührt, die von dem Trägerpaddel ausgehen und in Berührung mit der Rückseite stehen.

4. Bauteil nach einem der vorhergehenden Ansprüche mit einem Film aus dielektrischem Material (17) zwischen dem Halbleiter-Chip und dem oder den Unterkreuzungsgliedern, wobei der Film Öffnungen aufweist, durch die die Rückseite des Halbleiter-Chips das Paddel berührt.

5. Bauteil nach Anspruch 4 und 3, bei dem die Stifte einstückig mit dem Paddel ausgebildet sind und durch die Öffnungen führen.

## Revendications

1. Un dispositif à circuit intégré comprenant un cadre de montage qui comporte une palette de support de puce (11) et un ou plusieurs éléments d'interconnexion de niveau inférieur (12, 13), une puce de semiconducteur (21) qui recouvre la palette de support de puce et le ou les éléments d'interconnexion de niveau inférieur, la face arrière de la puce étant en contact électrique avec la palette de support de puce, mais étant électriquement isolée de l'élément ou des éléments d'interconnexion de niveau inférieur, et des connexions par fils conducteurs (25—28) qui connectent électriquement par fils conducteurs (25—28) qui connectent électriquement l'élément d'interconnexion de niveau inférieur, ou chacun d'eux, à un ensemble de sites sur la puce.

2. Un dispositif selon la revendication 1, comportant au moins deux éléments d'interconnexion de niveau inférieur (11, 12).

3. Un dispositif selon la revendication 1 ou la revendication 2, dans lequel la face arrière de la puce de semiconducteur vient en contact avec la palette de support de puce au moyen de tétons (16) qui s'étendent à partir de la palette pour venir en contact avec la face arrière précitée.

4. Un dispositif selon l'une quelconque des revendications précédentes, comprenant une pellicule de matériau diélectrique (17) entre la puce et l'élément ou les éléments d'interconnexion de niveau inférieur, avec des ouvertures dans la pellicule, à travers lesquelles la face arrière de la puce vient en contact avec la palette.

5. Un dispositif selon la revendication 4, dépendant de la revendication 3, dans lequel les tétons sont formés d'un seul tenant avec la palette et traversent les ouvertures précitées.

FIG. 1

FIG. 2

FIG. 3